# EUROPÄISCHE PATENTSCHRIFT

(11) **EP 3 736 378 B1**
(45) Veröffentlichungstag und Bekanntmachung des Hinweises auf die Patenterteilung: **05.05.2021**
(21) Anmeldenummer: 19173275.9
(22) Anmeldetag: 08.05.2019
(51) Int. Cl.: E01C 19/48, B60R 11/02

(54) **EINBAUBOHLE MIT SCHNELLKUPPLUNG FÜR AUSSENBEDIENSTAND**
FITTED BOARD WITH QUICK COUPLING FOR EXTERNAL CONTROL CONSOLE
DAME DE MISE EN PLACE À ACCOUPLEMENT RAPIDE POUR UN POSTE DE COMMANDE EXTÉRIEUR

(43) Veröffentlichungstag der Anmeldung: 11.11.2020
(73) Patentinhaber: Joseph Vögele AG, 67067 Ludwigshafen (DE)
(72) Erfinder: EUL, Achim, 68305 Mannheim (DE); JUNGMANN, Karl-Heinz, 68647 Biblis (DE)
(74) Vertreter: Grünecker Patent- und Rechtsanwälte PartG mbB

(56) Entgegenhaltungen:
- EP-A1- 3 067 774
- WO-A1-2019/026830
- WO-A2-2015/014663

## Beschreibung

Die vorliegende Erfindung bezieht sich auf eine Einbaubohle zum Verdichten eines Einbaumaterials gemäß dem Anspruch 1.

Es ist bekannt, dass Straßenfertiger eine bewegbar gelagerte Einbaubohle zur Herstellung eines neuen Straßenbelags aufweisen. Es ist weiter bekannt, dass optional an der Einbaubohle für den Bediener ein Außenbedienstand mit einem Bedienpaneel zur Verfügung steht, woran sich spezifische Einbauparameter an der Einbaubohle einstellen lassen.

EP 2 644 454 A1 offenbart einen Außensteuerstand einer Einbaubohle mit einem daran vorgesehenen Bedienpaneel. Das Bedienpaneel verfügt an seiner Unterseite über einen Befestigungsabschnitt, womit es am Außensteuerstand befestigt werden kann. Gemäß einer Variante kann das Bedienpaneel mit seinem Befestigungsabschnitt auf ein rohrförmiges Element an einer Halterung der Einbaubohle aufgesteckt und daran gesichert werden. Des Weiteren ist am Bedienpaneel an dessen Unterseite, allerdings sowohl in konstruktiver als auch in funktionaler Hinsicht separat vom Befestigungsabschnitt, ein elektrischer Anschluss für einen elektrischen Kupplungsvorgang vorgesehen.

Die EP 2 578 748 A1 offenbart auch einen Außensteuerstand für eine Einbaubohle. Der Außensteuerstand verfügt über ein Bedienpaneel das in einer mechanischen Halterungsaufnahme befestigt wird. Außerdem weist das Bedienpaneel an dessen Unterseite elektrische Anschlüsse auf. Bei den oben beschriebenen bekannten Außenbedienständen müssen die jeweiligen Bedienpaneele mittels mehrerer Arbeitsschritte am jeweiligen Außenbedienstand angebaut und davon abgebaut werden. Es müssen insbesondere nacheinander und voneinander gesonderte Arbeitsschritte zur mechanischen und elektrischen Kupplung der jeweiligen Bedienpaneele am Außenbedienstand durchgeführt werden.

Hinzu kommt, dass an den bekannten Außenbedienständen ein separates elektrisches Kabel die Halterung mit dem Bedienpaneel elektrisch verbindet. Wenn das Bedienpaneel abgebaut wird, um es beispielsweise über Nacht vom Straßenfertiger zu entfernen, sollte das Kabel ebenfalls abmontiert werden, was insgesamt zu mehreren Abbauschritten führt. Ein Verbleib des Kabels, ohne am Bedienpaneel angebunden zu sein, ist unerwünscht.

Die EP 3 067 774 A1 offenbart eine Einbaubohle nach dem Oberbegriff des Anspruchs 1, mit einem Außenbedienstand, an welchem eine tragbare Displayeinheit innerhalb einer Dockingstation des Außenbedienstands lösbar befestigt ist.

Insgesamt ergibt sich daher im Hinblick auf die bekannte Praxis, insbesondere in Sachen Ergonomie, für das Anbringen und das Abnehmen des Bedienpaneels ein gewisses Verbesserungspotential.

Aufgabe der Erfindung ist es, die oben beschriebene bekannte Praxis dahingehend zu verbessern, dass sich ein Bedienpaneel am Außenbedienstand einer Einbaubohle einfach befestigen sowie einfach davon abbauen lässt.

Diese Aufgabe wird gelöst mittels einer Einbaubohle gemäß dem Anspruch 1. Verbesserte Weiterbildungen der Erfindung sind durch die jeweiligen technischen Merkmale der abhängigen Ansprüche gegeben.

Die Erfindung betrifft eine Einbaubohle zum Verdichten eines Einbaumaterials, umfassend mindestens einen Außenbedienstand für einen Bediener zum Steuern mindestens eines an der Einbaubohle einstellbaren Betriebsparameters, beispielsweise einer Einbaubreite, einer Geschwindigkeit der Verteilerschnecke und/oder Höheneinstellung der Verteilerschnecke. Der Außenbedienstand weist eine Halterung sowie mindestens ein daran lösbar befestigtes Bedienpaneel als Eingabeeinheit für den Bediener zum Einstellen des mindestens einen Betriebsparameters auf, wobei das Bedienpaneel mittels einer Steckverbindungseinrichtung an der Halterung befestigt ist.

Erfindungsgemäß umfasst die Steckverbindungseinrichtung einen ersten Steckverbinderteil mit mindestens einem daran integriert ausgebildeten ersten elektrischen Kontaktteil sowie einen zweiten Steckverbinderteil mit mindestens einem daran integriert ausgebildeten zweiten elektrischen Kontaktteil, wobei durch eine mechanische Kopplung der beiden Steckverbinderteile eine elektrische Kopplung der beiden an den beiden Steckverbinderteilen integrierten elektrischen Kontaktteile herstellbar ist.

Indem die jeweiligen elektrischen Kontaktteile integral an den jeweiligen Steckverbinderteilen ausgebildet sind, d.h. nicht an funktional oder lokal zu den Steckverbinderteilen gesonderten Koppelstellen, lässt sich das Bedienpaneel anhand eines vereinfachten Kopplungsvorgangs sowohl mechanisch als auch elektrisch am Außenbedienstand verbinden. Durch die integrale Ausführung der Steckverbindungseinrichtung wird insbesondere erreicht, dass eine ordnungsgemäße mechanische Anbringung des Bedienpaneels gleichzeitig dafür sorgt, dass dadurch, d.h. mittels desselben Kopplungsvorgangs bzw. Arbeitsschritts, eine zuverlässige elektrische Kopplung durchführbar ist, um das Bedienpaneel als Eingabeeinheit zum Ansteuern der Einbaubohle und/oder des Straßenfertigers einzusetzen.

Die Steckverbindungseinrichtung ist bei der Erfindung insbesondere als Schnellkupplung für einen einfachen An- und Abbau des Bedienpaneels ausgebildet. Damit lassen sich die zum An- und Abbau des Bedienpaneels am Außenbedienstand der Einbaubohle benötigten Arbeitsschritte reduzieren. Außerdem kann damit auf ein gesondertes Anschlusskabel zur elektrischen Verbindung verzichtet werden, wodurch sich insbesondere Herstellungskosten verringern lassen. Der Wegfall eines separaten elektrischen Verbindungskabels im Baustelleneinsatz kann auch im Hinblick auf (Arbeits-)Sicherheit am Arbeitsort vorteilhaft sein. Insgesamt ermöglicht die Erfindung eine ergonomische Handhabe des Bedienpaneels anhand der am Außenbedienstand der Einbaubohle bereitgestellten Steckverbindungseinrichtung. Insbesondere ermöglicht es die Erfindung, das Bedienpaneel am Außenbedienstand der Einbaubohle mittels eines mechanischen Kupplungsvorgangs gleichzeitig, d.h. ohne zusätzlichen Montageschritt, elektrisch am Außenbedienstand zu verbinden. Somit lässt sich sowohl die mechanische als auch die elektrische Kopplung am Außenbedienstand mittels einer standardisierten besonders einfachen, dem Bediener zugutekommenden Handhabe durchführen. Vorzugsweise sind der erste Steckverbinderteil integral an der Halterung und der zweite Steckverbinderteil integral am Bedienpaneel des Außenbedienstands ausgebildet. Damit können die jeweiligen Steckverbinderteile intuitiv vom Bediener verbunden werden.

Für eine stabile und sichere Anbringung des Bedienpaneels am Außenbedienstand ist es erfindungsgemäß vorgesenen, dass die Steckverbindungseinrichtung einen Sperrmechanismus aufweist. Damit kann das Bedienpaneel insbesondere gegen ein Herunterfallen gesichert an der Halterung befestigt werden.

Erfindungsgemäß sieht der Sperrmechanismus mindestens einen federkraftbelasteten Griff am Bedienpaneel vor. Vorzugsweise ist der Griff an einer Unterseite des Bedienpaneels angeordnet und/oder mittels einer Federkraft in einer Verriegelungsposition vorgespannt gelagert. Eine Variante sieht vor, dass der Griff an der Unterseite des Bedienpaneels befestigt ist, wobei ein Bediener durch Hintergreifen des Bedienpaneel den Griff zu dessen manueller Betätigung erreicht.

Vorzugsweise ist der Griff als optisch für den Bediener wahrnehmbarer Signalgeber für eine ordnungsgemäße Befestigung des Bedienpaneels an der Halterung des Außenbedienstands ausgebildet. Eine vorteilhafte Variante sieht vor, dass als Anzeige für eine ordnungsgemäße Befestigung des Bedienpaneels an der Halterung der Griff für einen Bediener sichtbar zumindest teilweise über eine Kante des Bedienpaneels hinausragt. Beispielsweise könnte ein Teil des Griffs in eine zum Halten des Bedienpaneels ausgebildete Eingriffsmulde hineinragen oder über eine Seitenwand des Bedienpaneels zumindest teilweise hinausstehen, um die ordnungsgemäße Befestigung des Bedienpaneels an der Halterung anzuzeigen.

Gemäß einer Variante ist eine ordnungsgemäße mechanische und/oder elektrische Kopplung an der Steckverbindungseinrichtung anhand eines Symbols auf einem Display des Bedienpaneels anzeigbar. Zum Detektieren einer ordnungsgemäßen mechanischen und/oder elektrischen Kopplung kann am Außenbedienstand mindestens eine Sensoreinheit ausgebildet sein.

Eine besonders zielgerichtete Verbindung des Bedienpaneels am Außenbedienstand kann dadurch erreicht werden, dass die Steckverbindungseinrichtung eine Linearführung zum Verbinden der beiden Steckverbinderteile aufweist. Mittels der Linearführung kann dem Bediener aktiv dabei geholfen werden, das Bedienpaneel einwandfrei, d.h. sowohl mechanisch als auch elektrisch, am Außenbedienstand der Einbaubohle zu befestigen.

Vorzugsweise ist am Außenbedienstand, insbesondere an einer Oberseite der Halterung, eine Beleuchtungseinheit zum Ausleuchten der Linearführung vorgesehen. Vorteilhaft wäre es, wenn die Beleuchtungseinheit durch einen Abbau des Bedienpaneels automatisch anschaltbar ist. Außer ihrer eigentlichen Funktion zum Beleuchten der Linearführung kann die Beleuchtungseinheit insbesondere bei Schlechtwetter- und/oder Nachtarbeiten auch als optisches Mittel zur Anzeige der eingestellten Einbaubreite dienen, sprich eine Querverstellung der Einbaubohle anzeigen.

Die Beleuchtungseinheit kann derart konfiguriert sein, dass sie im angebrachten Zustand des Bedienpaneels für dieses zumindest umfangseitig als Hintergrundbeleuchtung optisch wahrnehmbar ist. Optional kann die Beleuchtungseinheit derart ausgebildet sein, dass sich damit der Griff des Sperrmechanismus belichten lässt, wenn das Bedienpaneel am Außenbedienstand befestigt ist.

Eine in konstruktiver Hinsicht besonders einfache aber zweckmäßige Ausführungsform sieht vor, dass die Linearführung mindestens zwei parallel angeordnete Führungsschienen aufweist. Der mechanische sowie elektrische Kupplungsvorgang sind damit besonders einfach durchzuführen. Entlang der Führungsschienen können LED-Leisten ausgebildet sein, die insbesondere zur Beleuchtungseinheit der Linearführung gehören.

Vorzugsweise ist am Ende des Kupplungsvorgangs die elektrische Kopplung für das Bedienpaneel kabellos hergestellt. Dies macht den Kupplungsvorgang einfach und reduziert insgesamt die im Baustellenbetrieb eingesetzten Komponenten am Straßenfertiger, wodurch ein insbesondere praktischer und ergonomischer Betrieb gewährleistet wird.

Eine verbesserte Ausführungsvariante sieht vor, dass ein ordnungsgemäßer Kopplungsvorgang durch ein, gegebenenfalls sogar bei laufender Maschine, hörbares akustisches Signal bestätigbar ist. Vorstellbar wäre ein akustisch ausgebbares Einrastgeräusch, das beispielsweise durch eine ordnungsgemäße mechanische Anbringung des Bedienpaneels, wodurch auch die elektrische Verbindung entsteht, mithilfe des Sperrmechanismus erzeugbar ist.

Zur weiteren Verbesserung kann vorgesehen sein, dass das Bedienpaneel am Außenbedienstand auf einer höhenverstellbar und/oder neigbar gelagerten Basisplatte der Halterung angeordnet ist. Damit kann der Bediener die Höhenlage und Ausrichtung des Bedienpaneels individuell seinen Bedürfnissen entsprechend einstellen.

Eine vorteilhafte Ausführungsform sieht vor, dass die Halterung eine daran ausgebildete bewegbar gelagerte Schutzklappe für die Steckverbindungseinrichtung aufweist. insbesondere kann die Schutzklappe dazu konfiguriert sein, dass sie im Fall einer Herausnahme des Bedienpaneels aus der Halterung federkraftbelastet am elektrischen Kontaktteil der Halterung angedrückt wird, um deren elektrische Anschlüsse vor Wetter- und Schmutzeinwirkung auf der Baustelle zu schützen. Eine in funktionaler Hinsicht ähnlich ausgebildete Schutzklappe kann auch am Bedienpaneel vorgesehen sein.

Zweckmäßig für einen komplexen Einsatz wäre es, wenn der Außenbedienstand ein weiteres, separat ausgebildetes Bedienpaneel als Eingabeeinheit für den Bediener zum Einstellen mindestens eines Betriebsparameters der Einbaubohle aufweist, wobei das weitere Bedienpaneel mittels einer eigens dafür vorgesehenen Steckverbindungseinrichtung, die insbesondere in funktionaler und technischer Hinsicht zum Herstellen einer mechanischen und elektrischen Kopplung vergleichbar ausgebildet ist (d.h. ähnliche Handhabevorteile aufweist, wie das zuvor beschriebene Bedienpaneel), an der Halterung lösbar befestigt ist. Damit können spezifische Steuer- beziehungsweise Einstellvorgänge an der Einbaubohle und/oder am Straßenfertiger über die jeweiligen gesondert an der Halterung befestigten Bedienpaneele separat durchgeführt werden. Vorzugsweise lassen sich über die beiden separat vorliegenden Bedienpaneele verschiedene Funktionsmodule am Straßenfertiger und/oder an der Einbaubohle steuern.

Besonders ergonomisch im Einsatz, aber auch optisch vorteilhaft wäre es, wenn die beiden Bedienpaneele an der Halterung neben- oder übereinander in einer gemeinsamen Montageebene angeordnet sind. Die beiden Bedienpaneele lassen sich damit optisch im Wesentlichen als gemeinsame Steuerplattform am Außenbedienstand der Einbaubohle wahrnehmen. Durch die Aufteilung jeweiliger Bedien- und Steuerfunktionen auf verschiedene Bedienpaneele kann der Bediener je nach Einsatzzweck das jeweilige Bedienpaneel vom Außenbedienstand abnehmen, während das andere daran befestigt bleibt. Dies ermöglicht einen ergonomischen Einsatz im Baustellenbetrieb.

Eine vorteilhafte Variante sieht vor, dass die beiden Bedienpaneele zum Herstellen der jeweiligen mechanischen und elektrischen Kopplung in entgegengesetzten Steck- bzw. Montagerichtungen an der Halterung anbaubar, insbesondere aufschiebbar, und abbaubar sind. Dadurch lassen sich die jeweiligen Bedienpaneele kompakt an der Halterung, dicht nebeneinander anbringen.

Besonders hilfreich ist es, wenn der Außenbedienstand an einem Seitenschieber der Einbaubohle befestigt ist. Das Bedienpaneel kann somit je nach hergestellter Einbaubreite seitwärts verlagert werden und ist damit seitlich an der Einbaubohle für einen dort mitlaufenden Bediener stets in Reichweite angeordnet.

Insbesondere bei der Herstellung großer Einbaubreiten kann es vorteilhaft sein, wenn die Einbaubohle zwei, an gegenüberliegenden Seiten der Einbaubohle montierte Außenbedienstände aufweist. Die jeweiligen Außenbedienstände können gemeinsame, aber auch verschiedene Eingabe- und Steuerfunktionen aufweisen.

Vorzugsweise weist die Steckverbindungseinrichtung Druckmittel auf, die zur Erhöhung eines elektrischen Kontaktdrucks am Ende des Kupplungsvorgangs ausgebildet sind. Vorstellbar wäre es, dass der weiter oben in Zusammenhang mit dem Sperrmechanismus genannte Griff zusätzlich als Druckmittel ausgebildet ist, um die Erhöhung des elektrischen Kontaktdrucks zwischen den jeweiligen elektrischen Kontaktteilen am Ende des Kupplungsvorgangs sicherzustellen.

Gemäß einer Variante ist an der Steckverbindungseinrichtung den daran ausgebildeten elektrischen Kontaktteilen mindestens eine Dichtung zugeordnet, die im angebrachten Zustand des Bedienpaneels am Außenbedienstand insbesondere sicherstellt, dass keine Feuchtigkeit oder Schmutz in den elektrischen Kontaktbereich eindringt.

Die Erfindung betrifft auch einen Straßenfertiger zum Herstellen eines Straßenbelags mit einer Einbaubohle der zuvor erfindungsgemäß beschriebenen Art.

Ausführungsbeispiele der Erfindung werden anhand der folgenden Figuren genauer erläutert. Es zeigen:
- Figur 1: einen Straßenfertiger zum Herstellen eines Straßenbelags, einschließlich einer daran befestigten Einbaubohle,
- Figur 2: einen isoliert dargestellten Außenbedienstand der Einbaubohle,
- Figur 3: den Außenbedienstand aus Figur 2 mit abgenommenem Bedienpaneel,
- Figur 4: den Außenbedienstand aus Figur 2 aus einer von unten dargestellten Ansicht,
- Figur 5: einen an der Halterung des Außenbedienstands ausgebildeten Teil der Steckverbindungseinrichtung,
- Figur 6: einen am Bedienpaneel des Außenbedienstands ausgebildeten Teil der Steckverbindungseinrichtung,
- Figur 7: einen schematisch sowie perspektivisch von hinten dargestellten Außenbedienstand mit zwei separaten Bedienpaneelen,
- Figur 8: eine perspektivische Darstellung eines Außenbedienstands der Einbaubohle mit zwei daran angebrachten Bedienpaneelen,
- Figur 9: eine Halterung eines Außenbedienstands zur Anbringung zwei separater Bedienpaneele, und
- Figur 10: die Halterung aus Figur 9 mit lediglich einem daran befestigten Bedienpaneel.

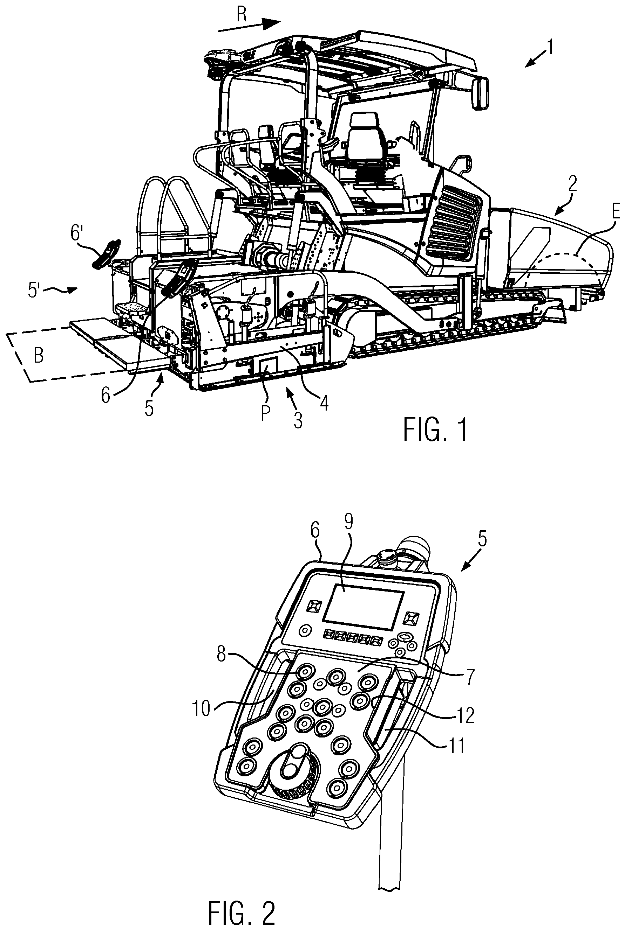

Figur 1 zeigt einen Straßenfertiger 1 zur Herstellung eines Straßenbelags B. Der Straßenfertiger 1 verfügt über einen Gutbunker 2 zur Aufnahme eines Einbaumaterials E. Das Einbaumaterial E wird aus dem Gutbunker 2 heraus mittels einer nicht gezeigten Längsfördereinrichtung entgegen einer Einbaurichtung R nach hinten zu einer am Straßenfertiger 1 bewegbar gelagerten Einbaubohle 3 transportiert. Das Einbaumaterial E wird vor der Einbaubohle 3 ausgebreitet und von der Einbaubohle 3 verdichtet, um den neuen Straßenbelag B herzustellen.

Die Einbaubohle 3 verfügt über einen Seitenschieber 4 mit einem daran ausgebildeten Außenbedienstand 5. Am Außenbedienstand 5 ist ein Bedienpaneel 6 als funktonale Eingabeeinheit für einen Bediener befestigt. Mittels des Bedienpaneel 6 können eine Vielzahl von Betriebsparametern der Einbaubohle 3 und/oder des Straßenfertigers 1 eingestellt sowie daran momentan für den Betrieb eingestellte Betriebsparameter abgerufen werden. Figur 1 zeigt in schematischer Darstellung einen Betriebsparameter P, der beispielsweise eine einstellbare Leistung einer an der Einbaubohle 3 ausgebildeten Bohlenheizung betrifft.

Des Weiteren zeigt Figur 1 einen auf der anderen Seite der Einbaubohle 3 montierten Außenbedienstand 5' mit einem daran befestigten weiteren Bedienpaneel 6', das vergleichbar mit dem Bedienpaneel 5 an- und abbaubar ist.

Figur 2 zeigt in isolierter Darstellung den Außenbedienstand 5 der Einbaubohle 3. Das gemäß Figur 2 am Außenbedienstand 5 montierte Bedienpaneel 6 weist an dessen Oberseite 7 eine Vielzahl von Eingabeschaltern 8 für den Bediener auf. Ferner verfügt das Bedienpaneel 6 in einem oberen Abschnitt an dessen Oberseite 7 ein Display 9 zum Darstellen aktuell eingestellter Betriebsparameter P, welches allerdings optional auch als Touchdisplay zur Einstellung verschiedener Betriebsparameter P ausgebildet sein kann. Ebenso kann das Display 9 eine ordnungsgemäße Anbringung des Bedienpaneels 6 am Außenbedienstand 5 anzeigen.

In der Figur 2 wird gezeigt, dass das Bedienpaneel 6 seitliche Eingriffsaussparungen 10 zum beiderseitigen Halten des Bedienpaneel 6 aufweist. Ferner zeigt Figur 2, dass in die rechte Eingriffsaussparung 10 ein Griff 11 hineinragt, der über eine seitliche Kante 12 des Bedienpaneels 6 für den Bediener sichtbar vorsteht, um so dem Bediener mit mechanischen Mitteln eine ordnungsgemäße Anbringung des Bedienpaneels 6 anzuzeigen.

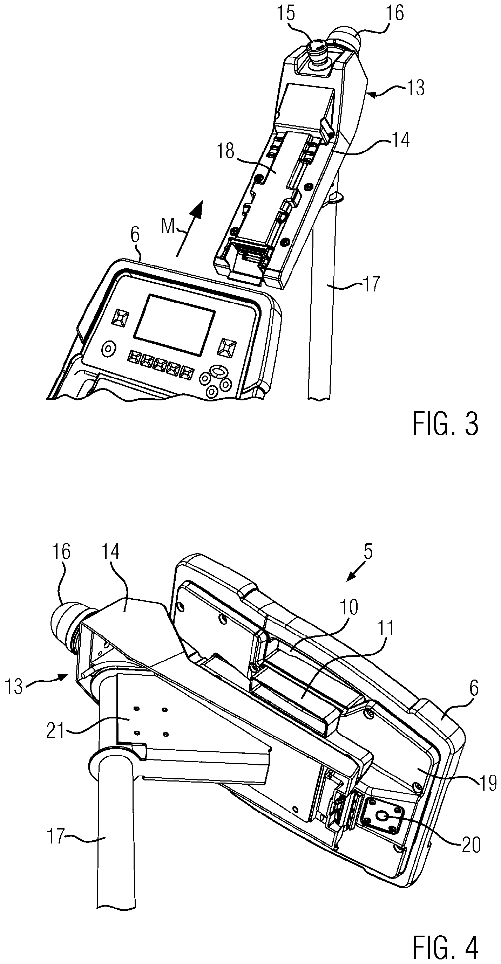

Figur 3 zeigt eine Halterung 13 des Außenbedienstands 5 ohne darauf montiertes Bedienpaneel 6. Die Halterung 13 ist in Form eines Montagesattels 14 ausgebildet, auf welchem das Bedienpaneel 6 entlang einer Montagerichtung M aufschiebbar ist. Ferner ist an der Halterung 13, separiert vom Montagesattel 14, ein Notausschalter 15 zum Anhalten des Einbaubetriebs ausgebildet. Außerdem zeigt Figur 3, dass die Halterung 13 mit einer Signaleinheit 16 ausgestattet ist, womit sich insbesondere die Positionierung des Außenbedienstands 5 anzeigen lässt, um beispielsweise während des Baustelleneinsatzes Kollisionen mit dem Außensteuerstand 5 zu vermeiden.

In Figur 3 ist die Halterung 13 auf einem Befestigungsrohr 17 höhenverstellbar gelagert. Ferner zeigt Figur 3 eine Basisplatte 18, die am Montagesattel 14 der Halterung 13 ausgebildet ist. Auf der Basisplatte 18 aufliegend kann das Bedienpaneel 6 lagestabil angeordnet werden, wenn es an der Halterung 13 des Außenbedienstands 5 befestigt ist.

Figur 4 zeigt den Außenbedienstand 5 aus einer Sicht von unten dargestellt. Das Bedienpaneel 6 verfügt über eine Unterseite 19, über die das Bedienpaneel 6 an der Halterung 13 befestigt ist. An der Unterseite 19 des Bedienpaneels 6 ist ein Untergrundstrahler 20 vorgesehen. Mittels des Untergrundstrahlers 20 kann der unmittelbar unterhalb des Bedienpaneels 6 vorliegende Untergrund, insbesondere eine Abschlusskante des neu hergestellten Straßenbelags B, ausgeleuchtet werden.

Ferner zeigt Figur 4 einen Befestigungsteil 21, womit die Halterung 13 am Montagerohr 17 angebracht ist. Der Befestigungsteil 21 ist dazu ausgebildet, die Halterung 13 höhenverstellbar sowie um die Längsachse des Montagerohrs 17 herum rotierbar zu lagern.

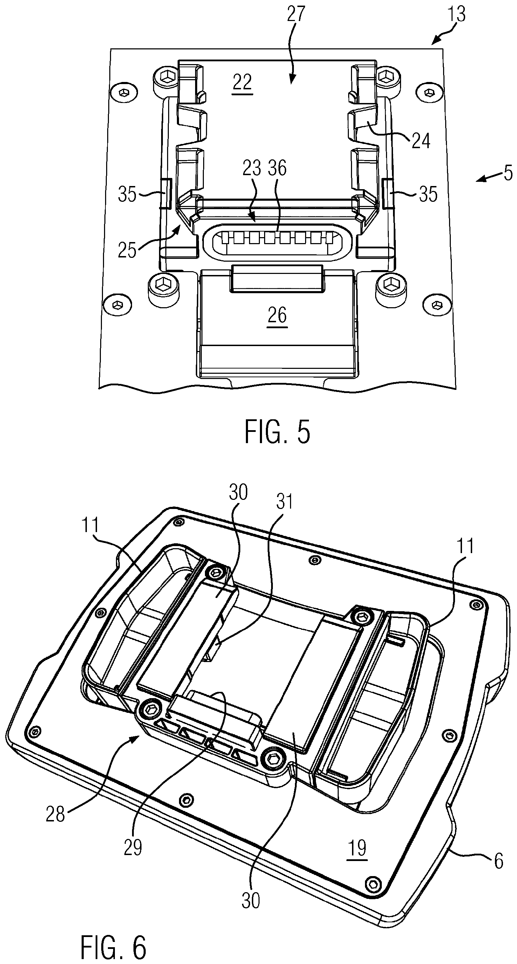

Figur 5 zeigt einen Teil der Halterung 13 des Außenbedienstands 5. In Figur 5 ist an der Halterung 13 ein erster Steckverbinderteil 22 mit einem daran integriert ausgebildeten ersten elektrischen Kontaktteil 23 dargestellt. Am ersten Steckverbinderteil 22 sind zwei parallel verlaufende Führungsschienen 24 ausgebildet. An der Halterung 13 bilden die beiden Führungsschienen 24 eine Linearführung 25 aus. Die Linearführung 25 umfasst zum Ausleuchten der jeweiligen Führungsschienen 24 eine Beleuchtungseinheit 35.

Ferner ist in Figur 5 eine Schutzklappe 26 zu sehen, die dem ersten elektrischen Kontaktteil 23 zugeordnet ist. Im nicht montierten Zustand des Bedienpaneels 6 an der Halterung 13 lässt sich der erste elektrische Kontaktteil 23 mittels der Schutzklappe 26 bedecken, um Witterungseinflüsse sowie eine Verschmutzung des ersten elektrischen Kontaktteil 23 zu vermeiden. Außerdem ist in Figur 5 dem ersten elektrischen Kontaktteil 23 eine daran ringsum verlaufende Dichtung 36 zugeordnet.

In Figur 5 ist der an der Halterung 13 vorgesehene erste Steckverbinderteil 22 als Teil einer Steckverbindungseinrichtung 27 ausgebildet, die beim An- und Abbau des Bedienpaneels 6 an der Halterung 13 eingesetzt wird. Die Steckverbindungseinrichtung 27 wird aus dem ersten Steckverbinderteil 22 zusammen mit dem nun in Zusammenhang mit Figur 6 beschriebenen zweiten Steckverbinderteil 28 ausgebildet, um das Bedienpaneel 6 an der Halterung 13 des Außenbedienstands 5 auf einfache Art und Weise befestigen zu können.

Der in Figur 6 dargestellte zweite Steckverbinderteil 28 der Steckverbindungseinrichtung 27 besitzt einen daran integriert ausgebildeten, an dem ersten elektrischen Kontaktteil 23 einsteckbaren zweiten elektrischen Kontaktteil 29, der zur Herstellung einer elektrischen Kopplung auf Kontakt am ersten elektrischen Kontaktteil 23 des ersten Steckverbinderteils 22 aus Figur 5 andockbar ist.

Gemäß Figur 6 ist der zweite Steckverbinderteil 28 an der Unterseite 19 des Bedienpaneels 6 ausgebildet. Die Steckverbindungseinrichtung 27 verfügt am zweiten Steckverbinderteil 28 über zwei parallel angeordnete Montageschienen 30, die zusammen mit den in Figur 5 gezeigten Führungsschienen 24 die Linearführung 25 ausbilden. Ferner sind an der Unterseite 19 des Bedienpaneels 6 zwei seitlich verschiebbar gelagerte Griffe 11 gezeigt, die vom Bediener zum An- und Abbau des Bedienpaneels 6 an der Halterung 13 manuell bedienbar sind. Die beiden Griffe 11 umfassen jeweils einen Verriegelungsvorsprung 31, womit sich das Bedienpaneel 6 an der Halterung 13, insbesondere am daran ausgebildeten ersten Steckverbinderteil 22 sichern und insbesondere auf Druck vorbelastet elektrisch koppeln lässt.

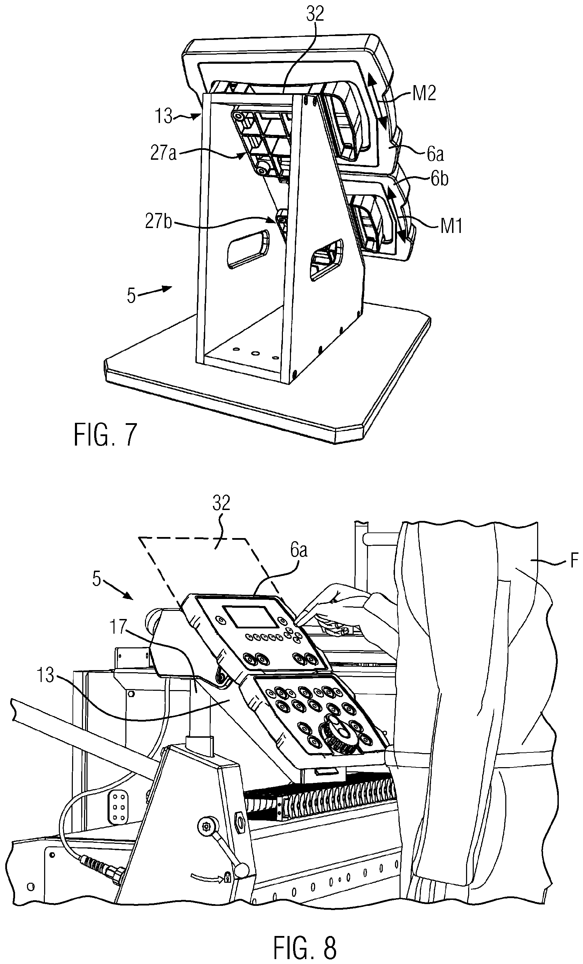

Figur 7 zeigt in schematischer Rückansicht einen Außenbedienstand 5 der Einbaubohle 3 mit zwei separat ausgebildeten, daran befestigten Bedienpaneelen 6a, 6b. Für die jeweiligen Bedienpaneele 6a, 6b ist jeweils eine gesondert an der Halterung 13 ausgebildete Steckverbindereinrichtung 27a, 27b vorgesehen, um die jeweiligen Bedienpaneele 6a, 6b lösbar am Außenbedienstand 5 zu befestigten.

Figur 7 zeigt auch, dass die beiden Bedienpaneele 6a, 6b übereinander in einer gemeinsamen schematisch angedeuteten Montageebene 32 an der Halterung 13 angeordnet sind. Die beiden Bedienpaneele 6a, 6b können an der Halterung 13 in entgegengesetzten Montagerichtungen M1, M2 angebracht und dazu entgegengesetzt abgebaut werden.

Figur 8 zeigt einen Außenbedienstand 5 in schematisch perspektivischer Darstellung mit entlang der Montageebene 32 zwei übereinander an der Halterung 13 befestigten Bedienpaneelen 6a, 6b, die als separate Bedienmodule an der Halterung 13 angeordnet sind. Hinter dem Außenbedienstand 5 ist ein Bediener F positioniert. Die jeweiligen Bedienpaneele 6a, 6b lassen sich vom Bediener F jeweils separat als Eingabeeinheit von der Halterung 13 abnehmen, um gegebenenfalls als mobile Eingabeeinheit im Bereich des Straßenfertigers 1, insbesondere im Bereich der Einbaubohle 3, genutzt zu werden.

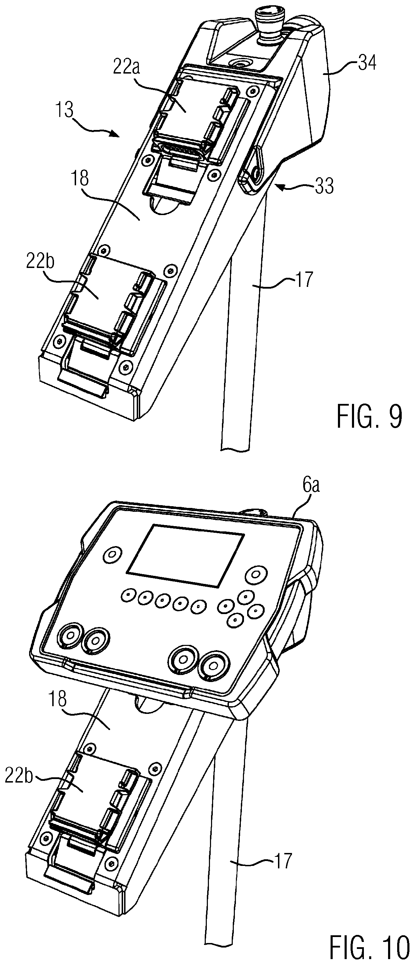

Figur 9 zeigt eine Halterung 13 zur Anbringung zwei separat ausgebildeter Bedienpaneele 6a, 6b. An der Basisplatte 18 der Halterung 13 sind übereinander erste Steckverbinderteile 22a, 22b zur Anbringung der jeweiligen Bedienpaneele 6a, 6b ausgebildet. Figur 9 zeigt auch, dass die Basisplatte 18 mittels einer Schwenkverbindung 33 an einem oberen Teil 34 der Halterung 13 befestigt ist. Mit Hilfe der Schwenkverbindung 33 lässt sich die Basisplatte 18 in eine gewünschte geneigte Ausrichtung verstellen, um die an der Halterung 13 befestigten Bedienpaneele 6a, 6b auszurichten.

Figur 10 zeigt die in Figur 9 dargestellte freie Halterung 13 mit einem am oberen ersten Steckverbinderteil 22a befestigten Bedienpaneel 6a.

Die in Zusammenhang mit der Steckverbindungseinrichtung beschriebenen Merkmale können sowohl an einem Außenbedienstand zur Anbringung eines als auch zur Anbringung mehrerer separater Bedienpaneele eingesetzt werden. Unabhängig davon, ob an der Einbaubohle ein Außenbedienstand mit lediglich einem Bedienpaneel oder mit mehreren Bedienpaneelen zum Einsatz kommt, lassen sich die Bedienpaneele mittels der erfindungsgemäßen Steckverbindungseinrichtung sowohl mechanisch als auch elektrisch auf ergonomische Art und Weise mittels eines einzigen Kopplungsvorgangs einfach am Außenbedienstand anbringen beziehungsweise davon abnehmen.

## Patentansprüche

1. Einbaubohle (3) zum Verdichten eines Einbaumaterials (E), umfassend mindestens einen Außenbedienstand (5) für einen Bediener (F) zum Steuern mindestens eines an der Einbaubohle (3) einstellbaren Betriebsparameters (P), beispielsweise einer Bohleneinbaubreite, wobei der Außenbedienstand (5) eine Halterung (13) sowie mindestens ein daran lösbar befestigtes Bedienpaneel (6) als Eingabeeinheit für den Bediener (F) zum Einstellen des Betriebsparameters (P) aufweist, wobei das Bedienpaneel (6) mittels einer Steckverbindungseinrichtung (27) an der Halterung (13) befestigt ist, wobei die Steckverbindungseinrichtung (27) einen ersten Steckverbinderteil (22) mit mindestens einem daran integriert ausgebildeten ersten elektrischen Kontaktteil (23) sowie einen zweiten Steckverbinderteil (28) mit mindestens einem daran integriert ausgebildeten zweiten elektrischen Kontaktteil (29) aufweist, wobei durch eine mechanische Kopplung der beiden Steckverbinderteile (22, 28) eine elektrische Kopplung der beiden an den Steckverbinderteilen (22, 28) integrierten elektrischen Kontaktteile (23, 29) herstellbar ist, **dadurch gekennzeichnet, dass** die Steckverbindungseinrichtung (27) einen Sperrmechanismus (35) aufweist, wobei der Sperrmechanismus (35) mindestens einen federkraftbelasteten Griff (11) am Bedienpaneel (6) aufweist.

2. Einbaubohle nach Anspruch 1, **dadurch gekennzeichnet, dass** der erste Steckverbinderteil (22) integral an der Halterung (13) und der zweite Steckverbinderteil (28) integral am Bedienpaneel (6) des Außenbedienstands (5) ausgebildet sind.

3. Einbaubohle nach Anspruch 1 oder 2, **dadurch gekennzeichnet, dass** als Zeichen für eine ordnungsgemäße Befestigung des Bedienpaneels (6) an der Halterung (13) der Griff (11) für einen Bediener (F) sichtbar zumindest teilweise über eine Kante (12) des Bedienpaneels (6) hinausragt.

4. Einbaubohle nach einem der vorigen Ansprüche, **dadurch gekennzeichnet, dass** die Steckverbindungseinrichtung (27) eine Linearführung (25) zum Verbinden der beiden Steckverbinderteile (22, 28) aufweist, wobei vorzugsweise an der Steckverbindungseinrichtung (27) zum Beleuchten der Linearführung (25) mindestens eine Beleuchtungseinheit (35) vorgesehen ist.

5. Einbaubohle nach Anspruch 4, **dadurch gekennzeichnet, dass** die Linearführung (25) mindestens zwei parallel angeordnete Führungsschienen (24) aufweist.

6. Einbaubohle nach einem der vorigen Ansprüche, **dadurch gekennzeichnet, dass** am Ende des Kupplungsvorgangs die elektrische Kopplung für das Bedienpaneel (6) kabellos hergestellt ist.

7. Einbaubohle nach einem der vorigen Ansprüche, **dadurch gekennzeichnet, dass** das Bedienpaneel (6) am Außenbedienstand (5) auf einer höhenverstellbar und/oder neigbar gelagerten Basisplatte (18) der Halterung (13) angeordnet ist.

8. Einbaubohle nach einem der vorigen Ansprüche, **dadurch gekennzeichnet, dass** die Halterung (13) eine daran ausgebildete bewegbar gelagerte Schutzklappe (26) für die Steckverbindungseinrichtung (27) aufweist.

9. Einbaubohle nach einem der vorigen Ansprüche, **dadurch gekennzeichnet, dass** der Außenbedienstand (5) ein weiteres, separat ausgebildetes Bedienpaneel (6a, 6b) als Eingabeeinheit für den Bediener (F) zum Einstellen mindestens eines Betriebsparameters (P) der Einbaubohle (3) aufweist, wobei das weitere Bedienpaneel (6a, 6b) mittels einer eigens dafür vorgesehenen Steckverbindungseinrichtung (27a, 27b) an der Halterung (13) lösbar befestigt ist, wobei vorzugsweise die beiden Bedienpaneele (6a, 6b) an der Halterung (13) neben- oder übereinander in einer gemeinsamen Montageebene (32) angeordnet sind.

10. Einbaubohle nach Anspruch 9, **dadurch gekennzeichnet, dass** die beiden Bedienpaneele (6a, 6b) zum Herstellen der jeweiligen mechanischen und elektrischen Kopplung in entgegengesetzten Steckrichtungen (M1, M2) an der Halterung (13) aufschiebbar sind.

11. Einbaubohle nach einem der vorigen Ansprüche, **dadurch gekennzeichnet, dass** der Außenbedienstand (5) an einem Seitenschieber (4) der Einbaubohle (3) befestigt ist.

12. Einbaubohle nach einem der vorigen Ansprüche, **dadurch gekennzeichnet, dass** die Einbaubohle (3) zwei, an gegenüberliegenden Seiten der Einbaubohle (3) montierte Außenbedienstände (5, 5') aufweist.

13. Einbaubohle nach einem der vorigen Ansprüche, **dadurch gekennzeichnet, dass** die Steckverbindungseinrichtung (27) Druckmittel (31) aufweist, die zur Erhöhung eines elektrischen Kontaktdrucks am Ende des Kupplungsvorgangs ausgebildet sind.

14. Straßenfertiger (1) zum Herstellen eines Straßenbelags (B), umfassend eine Einbaubohle (3) gemäß einem der voranstehenden Ansprüche.

## Claims

1. Paving screed (3) for compacting a paving material (E), comprising at least one external control station (5) for an operator (F) for controlling at least one operating parameter (P) adjustable at the paving screed (3), for example a screed paving width, wherein the external control station (5) comprises a support (13) and at least one operating panel (6) detachably attached thereto as an input unit for the operator (F) for setting the operating parameter (P), wherein the operating panel (6) is attached to the support (13) by means of a plug connection device (27), wherein the plug connection device (27) comprises a first plug connector part (22) with at least one first electrical contact part (23) integrated thereon and a second plug connector part (28) with at least one second electrical contact part (29) integrated thereon, wherein an electrical coupling of the two plug contactor parts (23, 29) integrated on the plug connector parts (22, 28) can be produced by a mechanical coupling of the two plug connector parts (22, 28), **characterized in that** the plug connection device (27) has a locking mechanism (35), wherein the locking mechanism (35) has at least one spring-loaded handle (11) on the operating panel (6).

2. Paving screed according to claim 1, **characterized in that** the first plug connector part (22) is integrally formed on the support (13) and the second plug connector part (28) is integrally formed on the operating panel (6) of the external control station (5).

3. Paving screed according to claim 1 or 2, **characterized in that** as a sign of correct attachment of the operating panel (6) to the support (13), the handle (11) protrudes at least partially beyond an edge (12) of the operating panel (6) in a manner visible to an operator (F).

4. Paving screed according to one of the preceding claims, **characterized in that** the plug connection device (27) comprises a linear guide (25) for connecting the two plug connector parts (22, 28), wherein at least one lighting unit (35) is preferably provided on the plug connection device (27) for lighting the linear guide (25).

5. Paving screed according to claim 4, **characterized in that** the linear guide (25) has at least two guide rails (24) arranged in parallel.

6. Paving screed according to one of the preceding claims, **characterized in that** at the end of the coupling process the electrical coupling for the operating panel (6) is established without cables.

7. Paving screed according to one of the preceding claims, **characterized in that** the operating panel (6) at the external control station (5) is arranged on a height-adjustable and/or inclinable base plate (18) of the support (13).

8. Paving screed according to one of the preceding claims, **characterized in that** the support (13) has a movably mounted protective flap (26) formed thereon for the plug connection device (27).

9. Paving screed according to one of the preceding claims, **characterized in that** the external control station (5) has a further, separately designed operating panel (6a, 6b) as an input unit for the operator (F) for setting at least one operating parameter (P) of the paving screed (3), wherein the further operating panel (6a, 6b) is detachably fastened to the support (13) by means of a plug connection device (27a, 27b) provided specifically for this purpose, wherein preferably the two operating panels (6a, 6b) are arranged on the support (13) next to or above one another in a common mounting plane (32).

10. Paving screed according to claim 9, **characterized in that** the two operating panels (6a, 6b) can be pushed onto the support (13) in opposite plug-in directions (M1, M2) to establish the respective mechanical and electrical coupling.

11. Paving screed according to one of the preceding claims, **characterized in that** the external control station (5) is attached to a side shifting device (4) of the paving screed (3).

12. Paving screed according to one of the preceding claims, **characterized in that** the paving screed (3) has two external control stations (5, 5') mounted on opposite sides of the paving screed (3).

13. Paving screed according to one of the preceding claims, **characterized in that** the plug connection device (27) comprises pressure means (31) adapted to increase an electrical contact pressure at the end of the coupling process.

14. Road finisher (1) for producing a road surface (B), comprising a paving screed (3) according to one of the foregoing claims.

## Revendications

1. Table de réglage (3) permettant le compactage d'un matériau d'ouvrage (E), comprenant au moins un poste de commande extérieur (5) destiné à un opérateur (F) et permettant de commander au moins un paramètre de fonctionnement (P) pouvant être réglé au niveau de la table de réglage (3), par exemple une largeur d'ouvrage de table, dans laquelle le poste de commande extérieur (5) présente un support (13) et au moins un panneau de commande (6) fixé de manière amovible audit support et faisant office d'unité d'entrée pour l'opérateur (F) afin de régler le paramètre de fonctionnement (P), dans laquelle le panneau de commande (6) est fixé au support (13) au moyen d'un dispositif de connexion par fiches (27), dans laquelle le dispositif de connexion par fiches (27) présente une première partie formant connecteur enfichable (22) avec au moins une première pièce de contact électrique (23), formée d'un seul tenant au niveau de ladite première partie formant connecteur enfichable, et une seconde partie formant connecteur enfichable (28) avec au moins une seconde pièce de contact électrique (29) formée d'un seul tenant au niveau de ladite seconde partie formant connecteur enfichable, dans laquelle un couplage électrique des deux pièces de contact électrique (23, 29) formées d'un seul tenant au niveau des parties formant connecteur enfichable (22, 28) peut être produit grâce à un couplage mécanique des deux parties formant connecteur enfichable (22, 28), **caractérisée en ce que** le dispositif de connexion par fiches (27) présente un mécanisme de verrouillage (35), dans laquelle le mécanisme de verrouillage (35) présente au moins une poignée à ressort (11) au niveau du panneau de commande (6).

2. Table de réglage selon la revendication 1, **caractérisée en ce que** la première partie formant connecteur enfichable (22) est formée d'un seul tenant au niveau du support (13) et la seconde partie formant connecteur enfichable (28) est formée d'un seul tenant au niveau du panneau de commande (6) du poste de commande extérieur (5).

3. Table de réglage selon la revendication 1 ou 2, **caractérisée en ce que** la poignée (11) fait saillie au moins partiellement par-dessus un bord (12) du panneau de commande de manière visible pour un opérateur (F) en signe de fixation nominale du panneau de commande (6) au niveau du support (13).

4. Table de réglage selon l'une quelconque des revendications précédentes, **caractérisée en ce que** le dispositif de connexion par fiches (27) présente un guide linéaire (25) permettant de relier les deux parties formant connecteur enfichable (22, 28), dans laquelle au moins une unité d'éclairage (35) est de manière préférée prévue au niveau du dispositif de connexion par fiches (27) afin d'éclairer le guide linéaire (25).

5. Table de réglage selon la revendication 4, **caractérisée en ce que** le guide linéaire (25) présente au moins deux rails de guidage (24) agencés de manière parallèle.

6. Table de réglage selon l'une quelconque des revendications précédentes, **caractérisée en ce que** le couplage électrique destiné au panneau de commande (6) est établi sans fil à la fin de l'opération de couplage.

7. Table de réglage selon l'une quelconque des revendications précédentes, **caractérisée en ce que** le panneau de commande (6) est agencé au niveau du poste de commande extérieur (5) sur une plaque de base (18), réglable en hauteur et/ou inclinable, du support (13).

8. Table de réglage selon l'une quelconque des revendications précédentes, **caractérisée en ce que** le support (13) présente un volet de protection (26) destiné au dispositif de connexion par fiches (27) et réalisé au niveau dudit support de manière à être mobile.

9. Table de réglage selon l'une quelconque des revendications précédentes, **caractérisée en ce que** le poste de commande extérieur (5) présente un autre panneau de commande (6a, 6b) réalisé de manière séparée et faisant office d'unité d'entrée pour l'opérateur (F) afin de régler au moins un paramètre de fonctionnement (P) de la table de réglage (3), dans laquelle l'autre panneau de commande (6a, 6b) est fixé de manière amovible au support (13) au moyen d'un dispositif de connexion par fiches (27a, 27b) prévu spécifiquement à cet effet, dans laquelle les deux panneaux de commande (6a, 6b) sont agencés sur le support (13) de manière préférée côte à côte ou l'un au-dessus de l'autre dans un plan d'assemblage (32) commun.

10. Table de réglage selon la revendication 9, **caractérisée en ce que** les deux panneaux de commande (6a, 6b) peuvent être poussés au niveau du support (13) dans des directions d'enfichage (M1, M2) opposées afin de produire le couplage mécanique et électrique respectif.

11. Table de réglage selon l'une quelconque des revendications précédentes, **caractérisée en ce que** le poste de commande extérieur (5) est fixé à une glissière latérale (4) de la table de réglage (3).

12. Table de réglage selon l'une quelconque des revendications précédentes, **caractérisée en ce que** la table de réglage (3) présente deux postes de commande extérieurs (5, 5') assemblés au niveau de côtés opposés de la table de réglage (3).

13. Table de réglage selon l'une quelconque des revendications précédentes, **caractérisée en ce que** le dispositif de connexion par fiches (27) présente des moyens de pression (31) conçus pour augmenter la pression de contact électrique à la fin de l'opération de couplage.

14. Finisseur routier (1) permettant de produire un revêtement routier (B), comprenant une table de réglage (3) selon l'une quelconque des revendications précédentes.
